# EUROPEAN PATENT APPLICATION

(11) **EP 4 563 242 A1**
(43) Date of publication of application: **04.06.2025**
(21) Application number: 23926299.1
(22) Date of filing: 08.03.2023
(51) Int. Cl.: B05C 5/02, B05C 11/10, B05D 1/26

(54) **COATING HEAD, COATING DEVICE, AND COATING METHOD**

(71) Applicant: Kabushiki Kaisha Toshiba, Tokyo 105-0023 (JP); Toshiba Energy Systems & Solutions Corporation, Saiwai-ku Kawasaki-shi Kanagawa 2120013 (JP)
(72) Inventor: SHIDA Naomi, Tokyo 105-0023 (JP); NAITO Katsuyuki, Kawasaki-shi, Kanagawa 210-0024 (JP); HIRAOKA Toshiro, Tokyo 105-0023 (JP); TOBARI Tomohiro, Kawasaki-shi, Kanagawa 212-0013 (JP)
(74) Representative: Marks & Clerk LLP
(86) International application number: PCT/JP2023/008878
(87) International publication number: WO 2024/185089

(57) **Abstract**

According to an embodiment, there are provided a coating head, a coating device, and a coating method for forming a coating film by slit coating, the coating head, the coating device, and the coating method being capable of forming a uniform coating film. The coating head includes:
a manifold that temporarily stores a coating liquid in the manifold;
a slit through which the coating liquid stored in the manifold is ejected; and
a plurality of coating liquid supply ports through which the coating liquid is introduced into the manifold, in which
the manifold has a columnar shape and is arranged inside the coating head substantially in parallel to a longitudinal direction of the coating head, and
the plurality of coating liquid supply ports are arranged at both ends of the manifold in a longitudinal direction.

## Description

### TECHNICAL FIELD

Embodiments of the present invention relate to a coating head, a coating device, and a coating method that can be used for device formation.

### BACKGROUND ART

Organic thin-film solar cells using an organic semiconductor and organic/inorganic hybrid solar cells are expected as low-cost solar cells because an inexpensive coating method can be applied to form an active layer. In order to implement the organic thin-film solar cell and the organic/inorganic hybrid solar cell at low cost, it is required to uniformly apply a coating material for forming an organic active layer and other layers. The thickness of each layer is about several nm to several 100 nm, and it is required to form such a very thin layer with a large area and high uniformity. For example, a slit coating method is known as one of roll-to-roll (R2R) coating methods capable of forming an extremely thin layer over a large area at low cost. In slit coating, a coating liquid can be supplied from a wide slit to a base material, and it is easy to obtain a single large-area coating film. However, in the slit coating according to the related art, a difference is likely to occur in an ejection amount of the coating liquid in a longitudinal direction of the slit, and it may be difficult to obtain a coating film having a uniform thickness. Therefore, a coating head, a coating device, and a coating method capable of forming a more uniform coating film are desired.

### CITATION LIST

### PATENT LITERATURE

Patent Literature 1: JP 2013-215644 A

### SUMMARY OF THE INVENTION

### OBJECT OF THE INVENTION

Embodiments of the present invention provide a coating head, a coating device, and a coating method capable of forming a uniform coating film by slit coating.

### SOLUTION TO PROBLEM

Embodiments provided by the present invention are as follows:
[1] A coating head that is used for slit coating and ejects a coating liquid from a slit, the coating head including:
   a manifold that temporarily stores the coating liquid in the manifold;
   the slit through which the coating liquid stored in the manifold is ejected; and
   a plurality of coating liquid supply ports through which the coating liquid is introduced into the manifold, in which
   the manifold has a columnar shape and is arranged inside the coating head substantially in parallel to a longitudinal direction of the coating head, and
   the plurality of coating liquid supply ports are arranged at both ends of the manifold in a longitudinal direction.
[2] The coating head according to [1], in which a gap at a central portion of the slit in a longitudinal direction is wider than a gap at an end portion in the longitudinal direction.
[3] The coating head according to [1] or [2], further including a coating liquid supply port through which the coating liquid is introduced into a central portion of the manifold.
[4] The coating head according to any one of [1] to [3], in which an uneven structure is provided on an inner surface of the slit.
[5] The coating head according to any one of [1] to [4], in which an outer surface of the coating head from which the slit is exposed is a curved surface.
[6] The coating head according to any one of [1] to [4], in which an outer surface of the coating head from which the slit is exposed is a flat surface.
[7] A coating device for supplying a coating liquid to a surface of a base material and forming a coating film by slit coating, the coating device including:
   a coating head;
   a base material conveyance member that conveys the base material; and
   a coating liquid supply member that supplies the coating liquid to the coating head, in which
   the coating head includes:
      a manifold that temporarily stores the coating liquid in the manifold;
      a slit through which the coating liquid stored in the manifold is ejected; and
      a plurality of coating liquid supply ports through which the coating liquid is introduced into the manifold,
      the manifold has a columnar shape and is arranged inside the coating head substantially in parallel to a longitudinal direction of the coating head, and
      the plurality of coating liquid supply ports are arranged at both ends of the manifold in a longitudinal direction.
[8] The coating device according to [7], further including a coating head position adjustment member that controls a position of the coating head.
[9] The coating device according to [7] or [8], in which the coating liquid is supplied from one coating liquid supply member to the coating head.
[10] A coating method for applying a coating liquid to a base material by slit coating using a coating head, in which
   the coating head includes:
   a manifold that temporarily stores the coating liquid in the manifold;
   a slit through which the coating liquid stored in the manifold is ejected; and
   a plurality of coating liquid supply ports through which the coating liquid is introduced into the manifold,
   the manifold has a columnar shape and is arranged inside the coating head substantially in parallel to a longitudinal direction of the coating head,
   the plurality of coating liquid supply ports are arranged at both ends of the manifold in a longitudinal direction, and
   coating is performed by supplying the coating liquid to the plurality of coating liquid supply ports.
[11] The coating method according to [10], in which the slit is arranged so as to face upward for coating.

### BRIEF DESCRIPTION OF DRAWINGS

[Fig. 1] Fig. 1 is a schematic view illustrating a state of coating using a coating head according to a first embodiment.
[Fig. 2] Fig. 2 is a schematic cross-sectional view of the coating head according to the first embodiment in a direction perpendicular to a longitudinal direction.
[Fig. 3] Fig. 3 is a schematic cross-sectional view of the coating head according to the first embodiment in a direction horizontal to the longitudinal direction.
[Fig. 4] Fig. 4 is a schematic side view illustrating a coating device according to a second embodiment.
[Fig. 5] Fig. 5 is a flowchart illustrating a coating method according to a third embodiment.

### BEST MODE FOR CARRYING OUT THE INVENTION

Hereinafter, embodiments of the present invention will be described in detail with reference to the drawings.

Note that the drawings are schematic or conceptual, and a relationship between a thickness and a width of each portion, a ratio between sizes of portions, and the like are not necessarily the same as actual ones. In addition, even in a case of representing the same portion, dimensions and ratios may be illustrated differently from each other depending on the drawings.

Note that, in the present specification and the respective drawings, elements similar to those described above in the previously described drawings are denoted by the same reference numerals, and the detailed description thereof is appropriately omitted.

### (First Embodiment)

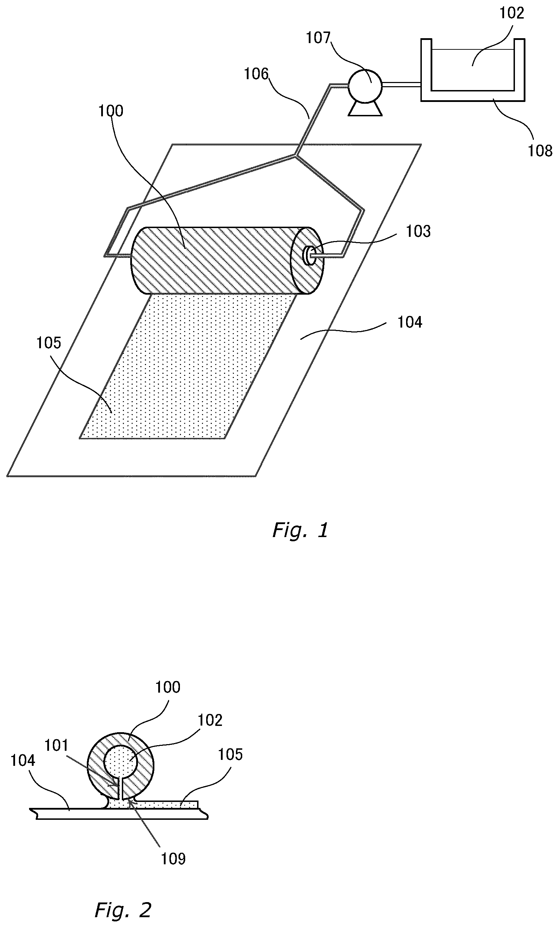

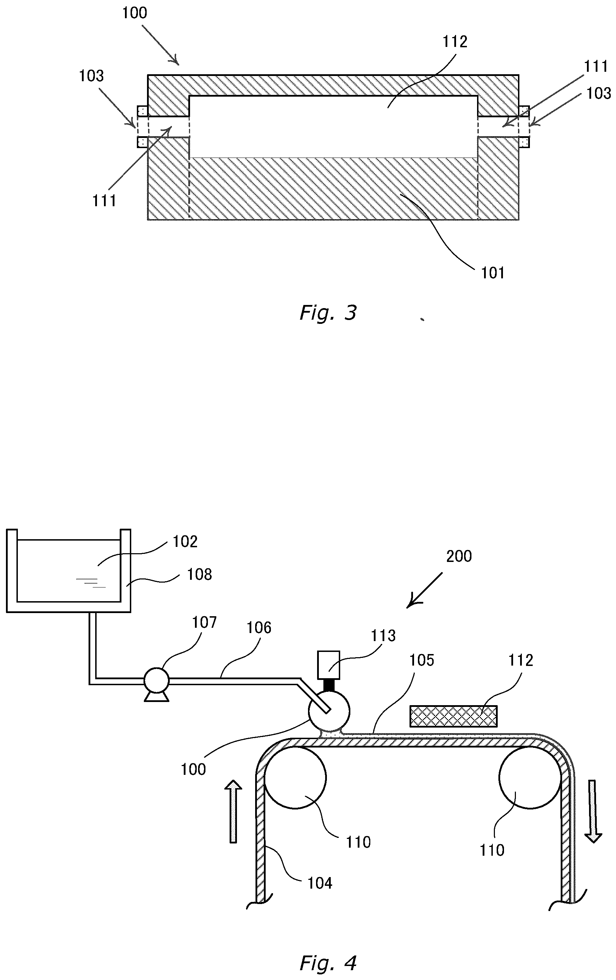

Fig. 1 is a schematic view illustrating a state of coating using a coating head according to a first embodiment. Figs. 2 and 3 are schematic cross-sectional views of the coating head according to the first embodiment in directions perpendicular to and parallel to a longitudinal direction.

As illustrated in the schematic view of Fig. 1, a coating device 100 according to the first embodiment includes coating liquid supply ports 103 for supplying a coating liquid 102 from both ends of the coating head in the longitudinal direction in the coating head that ejects the coating liquid from a slit 101 of the cross section illustrated in Fig. 2. In the drawing, a base material 104, a coating film 105, a pipe 106 that supplies the coating liquid to the coating head, a liquid feeding pump 107 which is a coating liquid supply member, and a coating liquid tank 108 are also illustrated.

As the coating liquid is supplied from both ends of the coating head in the longitudinal direction, it is easy to uniformly eject the coating liquid from the slit even if a length of the coating head in the longitudinal direction is 30 cm or more or 1 m or more.

As illustrated in Fig. 3, a manifold 112 in which the coating liquid temporarily stagnates and a flow path 111 from the coating liquid supply port 103 to the manifold are arranged in an internal structure of the slit of the coating head 100. An uneven structure can be provided on an inner surface of the slit 101. The manifold has a columnar shape and is arranged inside the coating head substantially in parallel to the longitudinal direction thereof.

When the coating liquid is supplied from both sides of the manifold arranged inside the coating head in the longitudinal direction, the coating liquid 102 collides at a central portion, and a pressure is locally increased or a turbulent flow is likely to occur. Such a pressure fluctuation and occurrence of the turbulent flow may cause variations in coating, but the manifold 112 and the uneven structure provided on the inner surface of the slit alleviate the variations.

In the coating head according to the first embodiment, a gap of the slit 101 may be uniform. However, the gap at a central portion of the slit in the longitudinal direction can be wider than a gap at an end portion in the longitudinal direction. As a result, it is easy to suppress the local increase in the pressure of the coating liquid and the occurrence of the turbulent flow.

The coating head 100 according to the first embodiment includes the coating liquid supply ports on both sides of the manifold arranged inside the coating head in the longitudinal direction, and may further include a coating liquid supply port for supplying a liquid at the central portion of the manifold 112. As a result, uniform liquid discharge from the slit is further facilitated.

In the coating head according to the first embodiment, an outer surface 109 of the slit 101 can be a curved surface as illustrated in Fig. 2. Here, the outer surface refers to a portion that can come into contact with the coating liquid. As the outer surface 109 is formed into a curved surface, a variation in a thickness of the coating film can be reduced even when a distance between the slit 101 and the base material 104 varies. A range of the outer surface in consideration of the shape is a range of two to five times of a slit width. Note that, in Fig. 2, a cross-sectional shape of the coating bar that is perpendicular to the longitudinal direction is circular, but the cross-sectional shape is not particularly limited.

In the coating head according to the first embodiment, the outer surface 109 of the slit 101 may be a flat surface. As the outer surface is formed into a flat surface, a shear stress increases, and in a case where a viscosity of the coating liquid is high, a uniform coating film can be easily obtained. In this case, the range of the outer surface is also a range of two to five times of the slit width.

### (Second Embodiment)

As illustrated in Fig. 4, a coating device 200 according to a second embodiment includes a coating head 100 having a slit 101, a base material conveyance member 110 that conveys a base material 104, and a pump 107 that is a coating liquid supply member that supplies a coating liquid 102 to the coating head 100.

As illustrated in Fig. 4, a coating film 105 is formed on the base material 104 by the coating liquid 102. An intended film (solid film) is obtained by solidifying the coating film 105 by, for example, drying. The coating film 105 having a large area can be formed on the base material 104, for example, by moving the base material 104 in a movement direction (an arrow direction in the drawing).

The coating device according to the second embodiment can include a coating head position adjustment member 113 that controls a position of the coating head. A thickness of the coating film can be made uniform by detecting the position of the coating head before or during coating and performing coating while controlling a distance between the coating head and the base material.

The coating device according to the second embodiment can supply the coating liquid 102 from one liquid feeding pump 107. Each of a plurality of pipes divided from one liquid feeding pump is connected to the coating head. Air present in the coating liquid more easily escapes when the liquid feeding pump 107 is positioned below the coating head 100. A coating liquid tank 108 is preferably positioned below the pump 107.

The coating device 200 may further include a drying member 114. The drying member 114 can dry the coating liquid 102 applied to the base material 104. The drying member 114 may include, for example, an air nozzle or a far-infrared lamp.

### (Third Embodiment)

A third embodiment relates to a coating method. In the coating method according to the embodiment, for example, coating is performed using the coating device 200 (and a modification thereof) described in the first embodiment.

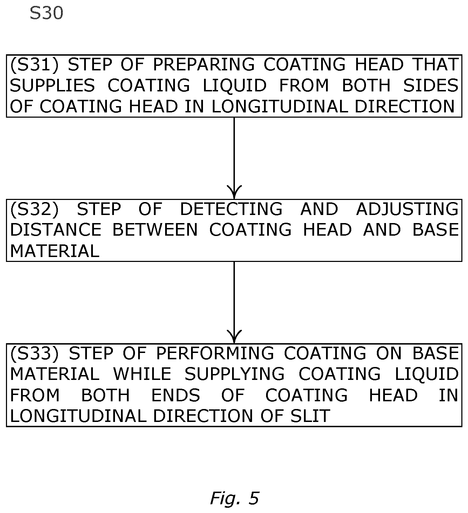

Fig. 5 is a flowchart illustrating the coating method (S30) according to the third embodiment. In the coating method, coating is performed using the coating head according to the first embodiment or the coating device according to the second embodiment.

The method is a method of ejecting and applying a coating liquid of a coating head having a slit, and includes: a step (S31) of preparing the coating head that supplies the coating liquid from both sides of the coating head in a longitudinal direction as described in the first embodiment; a step (S32) of detecting and adjusting a distance between the coating head and a base material; and a step (S33) of performing coating on the base material while supplying a liquid from both ends of the coating head in the longitudinal direction of the slit.

Fig. 4 illustrates an example of the coating device in which the slit is arranged so as to face downward. An orientation of the slit can be freely selected from a downward orientation, a side orientation, and an upward orientation, but air in the coating liquid more easily escapes, and a uniform pressure is more easily applied to the coating liquid when the coating liquid is ejected upward, so that stable coating tends to be performed, which is preferable.

Hereinafter, specific examples of the coating device and the coating method according to the embodiment will be described.

For example, a solar cell can be formed by coating with the coating device 200. In one example, the number of pumps is one. A pipe connected to one pump is divided in two and connected to the coating head.

For example, the base material 104 is a roll-shaped PET film. A width of the PET film is, for example, 330 mm. A light-transmissive electrode having a width of 300 mm is formed on the PET film by a roll-to-roll sputtering device. A sheet resistance of the electrode is, for example, 10 Ω/□. The electrode has, for example, a laminated structure of ITO film/Ag alloy/ITO film. For example, a plurality of electrodes are provided. A length of one of the plurality of electrodes is, for example, about 10 mm. An interval between the plurality of electrodes is, for example, 50 µm.

The coating head 100 described in the first embodiment is prepared. The width of the slit of the coating head 10 is 0.5 mm at the end and 1.0 mm at the central portion. A cross section of the outer surface has an arc shape. A radius of the arc is 10 mm. A length of the coating head is 300 mm. A material of the coating head is, for example, stainless steel (for example, SUS303).

In one example, a hole transport layer is formed by the coating liquid 102. In this case, the coating liquid 102 is an aqueous solution containing PEDOT and PSS.

For example, a gap ring or an actuator controls a relative positional relationship between the coating head and the base material.

The coating liquid 102 is continuously supplied by the liquid feeding pump 107 while the base material is conveyed. A movement speed of the base material 104 is, for example, 5 m/min. The drying member 114 blows heated dry air to the applied coating liquid 102. A solidified coating film is obtained from the coating liquid.

In the embodiment, another coating liquid may be further applied after the above coating. The another coating liquid contains, for example, a semiconductor material. The another coating liquid contains, for example, PTB7 ([poly{4,8-bis[(2-ethylhexyl)oxy]benzo[1,2-b:4,5-b']dithiophene-2,6-diyl-1t-alt-3-fluoro-2-[(2-ethylhexyl)carbonyl]thieno[3,4-b]thiophene-4,6-diyl}]) and PC70BM ([6,6]-phenyl-C71-butyric acid methylester). PTB7 is, for example, a p-type semiconductor. PC70BM is, for example, an n-type semiconductor. The another coating liquid further contains, for example, monochlorobenzene. An amount of PTB7 is 8 mg for 1 mL of monochlorobenzene. An amount of PC70BM is 12 mg for 1 mL of monochlorobenzene. Another coating liquid 22A is a dispersion liquid containing an organic semiconductor.

The another coating liquid is, for example, a semiconductor film of a solar cell. When applying the another coating liquid, a minimum distance between the coating head 100 and the base material 104 is 300 µm. A movement speed of the base material 102 is, for example, 5 m/min. After the coating, drying is performed by the drying member.

For example, there are an organic thin-film solar cell using an organic semiconductor and an organic/inorganic hybrid solar cell. By preparing such solar cells by the coating method, a high-performance solar cell can be prepared.

In the embodiment, the coating liquid may be applied to the base material at a position where the base material 104 is conveyed in a vertical direction. As a result, for example, an effect of gravity is applied to the meniscus, and a uniform film is easily obtained even at high speed.

According to the embodiments, the coating device and the coating method capable of forming a uniform coating film are provided.

The embodiments of the present invention have been described above with reference to specific examples. However, the present invention is not limited to the specific examples. For example, a specific configuration of each element such as the pipe, the pump, the nozzle, and a holding unit included in the coating device is included in the scope of the present invention as long as those skilled in the art can similarly carry out the present invention and obtain the same effect by appropriately selecting the configuration from known ranges.

In addition, a combination of any two or more elements of the respective specific examples within a technically possible range is also included in the scope of the present invention as long as the combination includes the gist of the present invention.

In addition, all the coating devices and coating methods that can be implemented by those skilled in the art by appropriately changing the design based on a coating head, the coating device, and the coating method described above as the embodiments of the present invention are also within the scope of the present invention as long as the coating devices and coating methods include the gist of the present invention.

In addition, those skilled in the art can conceive various changes and modifications within the scope of the idea of the present invention, and it is understood that the changes and modifications also fall within the scope of the present invention.

Although some embodiments of the present invention have been described, the embodiments have been presented as examples and are not intended to limit the scope of the invention. These novel embodiments can be implemented in various other forms, and various omissions, substitutions, and changes can be made without departing from the gist of the invention. The embodiments and modifications thereof are included in the scope and gist of the invention, and are included in the invention described in the claims and the equivalent scope thereof.

### REFERENCE SIGNS LIST

- 100: COATING HEAD
- 101: SLIT
- 102: COATING LIQUID
- 103: SUPPLY PORT
- 104: BASE MATERIAL
- 105: COATING FILM
- 106: PIPE
- 107: COATING LIQUID SUPPLY MEMBER
- 108: COATING LIQUID TANK
- 109: OUTER SURFACE
- 110: BASE MATERIAL CONVEYANCE MEMBER
- 111: FLOW PATH
- 112: MANIFOLD
- 113: COATING HEAD POSITION MEMBER
- 114: DRYING MEMBER
- 200: COATING DEVICE

## Claims

1. A coating head that is used for slit coating and ejects a coating liquid from a slit, said coating head comprising:
a manifold that temporarily stores said coating liquid in said manifold;
said slit through which said coating liquid stored in said manifold is ejected; and
a plurality of coating liquid supply ports through which said coating liquid is introduced into said manifold,
wherein
said manifold has a columnar shape and is arranged inside said coating head substantially in parallel to a longitudinal direction of said coating head, and
the plurality of coating liquid supply ports are arranged at both ends of said manifold in a longitudinal direction.

2. The coating head according to claim 1, wherein a gap at a central portion of said slit in a longitudinal direction is wider than a gap at an end portion in the longitudinal direction.

3. The coating head according to claim 1 or 2, further comprising a coating liquid supply port through which said coating liquid is introduced into a central portion of said manifold.

4. The coating head according to claim 1 or 2, wherein an uneven structure is provided on an inner surface of said slit.

5. The coating head according to claim 1 or 2, wherein an outer surface of said coating head from which said slit is exposed is a curved surface.

6. The coating head according to claim 1 or 2, wherein an outer surface of said coating head from which said slit is exposed is a flat surface.

7. A coating device for supplying a coating liquid to a surface of a base material and forming a coating film by slit coating, said coating device comprising:
a coating head;
a base material conveyance member that conveys said base material; and
a coating liquid supply member that supplies said coating liquid to said coating head,
wherein
said coating head includes:
a manifold that temporarily stores said coating liquid in said manifold;
a slit through which said coating liquid stored in said manifold is ejected; and
a plurality of coating liquid supply ports through which said coating liquid is introduced into said manifold,
said manifold has a columnar shape and is arranged inside said coating head substantially in parallel to a longitudinal direction of said coating head, and
the plurality of coating liquid supply ports are arranged at both ends of said manifold in a longitudinal direction.

8. The coating device according to claim 7, further comprising a coating head position adjustment member that controls a position of said coating head.

9. The coating device according to claim 7 or 8, wherein said coating liquid is supplied from one coating liquid supply member to said coating head.

10. A coating method for applying a coating liquid to a base material by slit coating using a coating head, wherein
said coating head includes:
a manifold that temporarily stores said coating liquid in said manifold;
a slit through which said coating liquid stored in said manifold is ejected; and
a plurality of coating liquid supply ports through which said coating liquid is introduced into said manifold,
said manifold has a columnar shape and is arranged inside said coating head substantially in parallel to a longitudinal direction of said coating head,
the plurality of coating liquid supply ports are arranged at both ends of said manifold in a longitudinal direction, and
coating is performed by supplying said coating liquid to the plurality of coating liquid supply ports.

11. The coating method according to claim 10, wherein said slit is arranged so as to face upward for coating.

## Amended claims

### Amended claims under Art. 19.1 PCT

1. A coating head that is used for slit coating and ejects a coating liquid from a slit, said coating head comprising:
a manifold that temporarily stores said coating liquid in said manifold;
said slit through which said coating liquid stored in said manifold is ejected; and
a plurality of coating liquid supply ports through which said coating liquid is introduced into said manifold,
wherein
said manifold has a columnar shape and is arranged inside said coating head substantially in parallel to a longitudinal direction of said coating head,
the plurality of coating liquid supply ports are arranged at both ends of said manifold in a longitudinal direction, and
a gap at a central portion of said slit in a longitudinal direction is wider than a gap at an end portion in the longitudinal direction.

2. (Canceled)

3. The coating head according to claim 1 or 2, further comprising a coating liquid supply port through which said coating liquid is introduced into a central portion of said manifold.

4. The coating head according to claim 1 or 2, wherein an uneven structure is provided on an inner surface of said slit.

5. The coating head according to claim 1 or 2, wherein an outer surface of said coating head from which said slit is exposed is a curved surface.

6. The coating head according to claim 1 or 2, wherein an outer surface of said coating head from which said slit is exposed is a flat surface.

7. A coating device for supplying a coating liquid to a surface of a base material and forming a coating film by slit coating, said coating device comprising:
a coating head;
a base material conveyance member that conveys said base material; and
a coating liquid supply member that supplies said coating liquid to said coating head,
wherein
said coating head includes:
a manifold that temporarily stores said coating liquid in said manifold;
a slit through which said coating liquid stored in said manifold is ejected; and
a plurality of coating liquid supply ports through which said coating liquid is introduced into said manifold,
said manifold has a columnar shape and is arranged inside said coating head substantially in parallel to a longitudinal direction of said coating head,
the plurality of coating liquid supply ports are arranged at both ends of said manifold in a longitudinal direction, and
a gap at a central portion of said slit in a longitudinal direction is wider than a gap at an end portion in the longitudinal direction.

8. The coating device according to claim 7, further comprising a coating head position adjustment member that controls a position of said coating head.

9. The coating device according to claim 7 or 8, wherein said coating liquid is supplied from one coating liquid supply member to said coating head.

10. A coating method for applying a coating liquid to a base material by slit coating using a coating head, wherein
said coating head includes:
a manifold that temporarily stores said coating liquid in said manifold;
a slit through which said coating liquid stored in said manifold is ejected; and
a plurality of coating liquid supply ports through which said coating liquid is introduced into said manifold,
said manifold has a columnar shape and is arranged inside said coating head substantially in parallel to a longitudinal direction of said coating head,
the plurality of coating liquid supply ports are arranged at both ends of said manifold in a longitudinal direction,
coating is performed by supplying said coating liquid to the plurality of coating liquid supply ports, and
a gap at a central portion of said slit in a longitudinal direction is wider than a gap at an end portion in the longitudinal direction.

11. The coating method according to claim 10, wherein said slit is arranged so as to face upward for coating.
